# EUROPÄISCHE PATENTSCHRIFT

(11) **EP 3 962 247 B1**
(45) Veröffentlichungstag und Bekanntmachung des Hinweises auf die Patenterteilung: **28.08.2024**
(21) Anmeldenummer: 21172858.9
(22) Anmeldetag: 23.03.2016
(51) Int. Cl.: H05K 5/00, G01S 19/35, H05K 7/20

(54) **STEUERGERÄT**
CONTROL DEVICE
APPAREIL DE COMMANDE

(30) Priorität: 10.04.2015 DE 102015206480
(43) Veröffentlichungstag der Anmeldung: 02.03.2022
(62) Teilanmeldung aus: 16711635.9
(73) Patentinhaber: Robert Bosch GmbH, 70442 Stuttgart (DE)
(72) Erfinder: HORTIG, Michael, 72800 Eningen U. A. (DE); ROJAHN, Martin, 72070 Tuebingen (DE); WOERNLE, Wolfgang, 72149 Neustetten (DE); SCHRIMPF, Thomas, 72768 Reutlingen (DE); LUDWIG, Matthias, 72116 Moessingen (DE)

(56) Entgegenhaltungen:
- EP-A1- 0 312 740
- EP-A1- 1 677 583
- EP-B1- 1 646 271
- DE-A1- 102013 206 999
- DE-A1- 19 921 692
- DE-B3- 102006 029 977
- DE-C1- 19 544 974
- US-A1- 2006 089 019

## Beschreibung

### Stand der Technik

Die Erfindung betrifft ein Steuergerät, wie es insbesondere als Bestandteil eines Navigationssystems oder zum automatisierten Fahren in Kraftfahrzeugen verwendet wird. Ein derartiges Steuergerät ist dazu ausgebildet, sowohl Informationen, welche über ein HF (Hochfrequenz)-Antennenkabel als Eingangssignale an das Steuergerät zugeführt werden, als auch Informationen von insbesondere innerhalb des Steuergeräts angeordneten Sensoren zu verarbeiten, um die genaue Position des Steuergeräts bzw. des Fahrzeugs zu ermitteln. Hierbei wird sich die Erkenntnis zunutze gemacht, dass eine exakte Navigation nur aufgrund der Kombination von satellitengestützten Informationen und Informationen von internen Sensoren möglich ist. Eine innerhalb eines derartigen Steuergeräts angeordnete elektrische bzw. elektronische Schaltung zeichnet sich dadurch aus, dass sie wenigstens ein wärmeerzeugendes Bauteil aufweist, das auf einem Schaltungsträger, insbesondere in Form von einer Leiterplatte, angeordnet ist. Darüber hinaus ist auf demselben oder aber auf einem anderen Schaltungsträger bzw. Leiterplatte das wenigstens eine Sensorelement angeordnet. Um insbesondere die Funktionalität des wenigstens einen Sensorelements möglichst wenig zu beeinflussen, ist es wesentlich, dass die Wärme von dem wärmeerzeugenden Bauteil möglichst effektiv aus dem Steuergerät ausgeleitet wird. Hierzu dient in der Praxis ein aus Metall bestehendes Wärmeleitelement. Darüber hinaus erfolgt die elektrische Kontaktierung eines derartigen Steuergeräts mittels eines Steckeranschlusskörpers, der Anschlusselemente trägt, die der elektrischen Kontaktierung des wenigstens einen Schaltungsträgers dienen. Insbesondere für den Großserieneinsatz sind die aus dem Stand der Technik bekannten Steuergeräte aus fertigungstechnischer Sicht bzw. aus Gründen möglichst geringer Herstellkosten noch nicht optimal ausgebildet. Darüber hinaus sind die Anforderungen an derartige Steuergeräte besonders hoch, wenn sie zum automatisierten Fahren benutzt werden, bei dem ein Fahren des Fahrzeugs ohne Fahrereingriff erfolgt. Hier ist eine sichere Funktion und damit beispielsweise eine zuverlässige Wärmeabfuhr von wärmeerzeugenden Bauteilen besonders wichtig.

Aus der DE 199 21 692 A1 ist ein Steuergerät, bekannt, das ein aus Metall bestehendes Außengehäuse aufweist, das neben einer Abschirmwirkung gleichzeitig der Wärmeableitung wenigstens eines wärmeerzeugenden Bauteils dient. Weiterhin weist das bekannte Steuergerät mehrere Sensorelemente auf, die in einem separaten Innengehäuse angeordnet sind. Aus der US 2006/089019 A1 und der EP 1 677 583 A1 sind weitere, Sensorelemente umfassende Steuergeräte bekannt, bei denen jeweils ein wärmeerzeugendes Bauteil beabstandet zu einem Außengehäuse des Steuergeräts angeordnet ist, welches wiederum in Art eines Wärmeleitelements wirkt. Aus der DE 10 2013 206999 A1 ist ein Steuergerät mit einem auf einer ersten Leiterplatte angeordneten wärmeerzeugenden Element, das thermisch mit einem Gehäuseboden verbunden ist, und Vibrationsdämpfungselementen zwischen der Leiterplatte und dem Gehäusedeckel bekannt. Die Dokumente DE 195 44 974 C1 und EP 0 312 740 A1 zeigen Steuergeräte mit einem Schaltungsträger und einem Drucksensor.

### Offenbarung der Erfindung

Ausgehend von dem dargestellten Stand der Technik liegt der Erfindung die Aufgabe zugrunde, ein Steuergerät, welches dazu ausgebildet ist, sowohl (Hochfrequenz-)Signale zu verarbeiten als auch der Aufnahme wenigstens eines Sensorelements dient, aus herstellungstechnischer Sicht sowie aus Gründen möglichst geringer Herstellkosten zu optimieren.

Diese Aufgabe wird erfindungsgemäß bei einem Steuergerät mit den Merkmalen des Anspruchs 1 gelöst.

Vorteilhafte Weiterbildungen des erfindungsgemäßen Steuergeräts sind in den Unteransprüchen aufgeführt.

In einer ersten, nicht der beanspruchten Erfindung entsprechenden konstruktiven Ausgestaltung, die ein besonders niedriges Gewicht des Gehäuses des Steuergeräts ermöglicht, wird vorgeschlagen, dass das Wärmeleitelement als Einlegeteil in einem im Wesentlichen aus Kunststoff bestehenden Gehäuseelement angeordnet ist, dass das Gehäuseelement einen Verbindungsbereich zur Verbindung des Gehäuseelements mit einem Trägerelement aufweist, und dass das Wärmeleitelement thermisch mit dem Verbindungsbereich verbunden ist. Mit anderen Worten gesagt bedeutet dies, dass die Wärmeleitung über das Wärmeleitelement in den Bereich einer Befestigungsstelle mit einem Trägerelement erfolgt, wobei durch die Ankopplung des Wärmeleitelements an den Verbindungsbereich eine optimale Übertragung der Wärme von dem Steuergerät an das Trägerelement erfolgt. Üblicherweise besteht ein derartiges, karosserieseitiges Trägerelement zumindest bereichsweise aus Metall und ermöglicht daher eine rasche und gute Ableitung der Wärme von dem Steuergerät.

Um einerseits die Aufgabe einer möglichst effektiven Wärmeableitung zu ermöglichen, und andererseits die Funktionalität des wenigstens einen Sensorelements zu gewährleisten bzw. zu verbessern, insbesondere mit Blick auf das Sensorelement einwirkende Vibrationen, wird vorgeschlagen, dass das wenigstens eine wärmeerzeugende Bauteil und dass wenigstens eine Sensorelement auf unterschiedlichen Schaltungsträgern angeordnet sind, wobei der Schaltungsträger für das wenigstens eine Sensorelement vibrationsgedämpft angeordnet ist. Eine derartige konstruktive Ausbildung hat insbesondere den Vorteil, dass die Wärmeübertragung von dem wenigstens einen wärmeerzeugenden Bauteil über eine relativ starre Verbindung zwischen dem Schaltungsträger, der das wenigstens eine wärmeerzeugende Bauteil trägt, und dem Wärmeleitelement erfolgen kann, während andererseits das wenigstens eine Sensorelement über den zweiten Schaltungsträger vibrationsgedämpft innerhalb des Steuergeräts angeordnet werden kann.

Zur Optimierung der Schwingungsentkopplung des wenigstens einen Sensorelements ist es in Weiterbildung des zuletzt gemachten Vorschlags vorgesehen, dass der das wenigstens eine Sensorelement tragende Schaltungsträger ausschließlich mit dem das wenigstens eine wärmeerzeugende Bauteil tragenden Schaltungsträger elektrisch verbunden ist, vorzugsweise durch eine mechanisch schwimmende Verbindung. Es findet somit bevorzugt keine elektrische Kontaktierung des das wenigstens eine Sensorelement tragenden Schaltungsträgers über insbesondere am Gehäuse angeordnete elektrische Anschlusselemente bzw. Anschlusspins statt, die ansonsten eine Übertragung von Vibrationen von dem Gehäuse an den den wenigstens einen Sensor tragenden Schaltungsträger begünstigen.

Alternativ hierzu ist es jedoch aus Gründen einer verbesserten Wärmeentkopplung zwischen den beiden Schaltungsträgern auch möglich, dass der das wenigstens eine Sensorelement tragende Schaltungsträger mit dem das wenigstens eine wärmeerzeugende Bauteil tragenden Schaltungsträger über in einem Gehäuseelement angeordnete Verbindungselemente mechanisch verbunden ist.

Eine besonders gute Wärmeabfuhr wird bewirkt, wenn das Wärmeleitelement gemäss der beanspruchten Erfindung durch ein aus Metall bestehendes Gehäuseelement, in Form des Gehäusebodens gebildet ist. Dadurch weist das Wärmeleitelement auch ohne thermische Ankopplung an ein Trägerelement eine relativ hohe Wärmespeicherkapazität sowie Abstrahlfläche auf, sodass eine besonders rasche und effektive Abkühlung des wärmerzeugenden Bauteils ermöglicht wird. In fertigungstechnisch bevorzugter Ausgestaltung des zuletzt gemachten Vorschlags ist es vorgesehen, dass der das Gehäuseelement bildende Gehäuseboden als Tiefziehteil, vorzugsweise aus Blech bestehend, ausgebildet ist, und dass der Gehäuseboden im Überdeckungsbereich mit dem wenigstens einen wärmeerzeugenden Bauteil eine Erhöhung bzw. Einformung aufweist, die thermisch mit dem Schaltungsträger für das wenigstens eine wärmeerzeugende Bauteil oder dem wärmeerzeugenden Bauteil gekoppelt ist. Eine derartige thermische Kopplung des Schaltungsträgers bzw. des Bauteils erfolgt dabei üblicherweise in Form eines Wärmeleitklebers.

Aus fertigungstechnischer Sicht ist es besonders vorteilhaft, wenn beim Vorhandensein eines rahmenförmigen Gehäuseelements dieses von einem aus Kunststoff bestehenden Deckel verschlossen ist. Dadurch wird insbesondere das benötigte Gehäusevolumen bei Verwendung von zwei Schaltungsträgern infolge einer vorteilhaften Fertigungsschrittfolge reduziert.

Darüber hinaus ist es aus Fertigungs- bzw. Kostengründen besonders vorteilhaft, wenn die Kontaktierungen zwischen den elektrischen Anschlusselementen und dem wenigstens einen Schaltungsträger über Einpressverbindungen ausgebildet sind.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
Fig. 1 die Bauteile eines ersten, nicht erfindungsgemässen Steuergeräts in einem vereinfachten Längsschnitt,
Fig. 2 die Bauteile des Steuergeräts der Fig. 1 in teilweise montiertem Zustand in einer perspektivischen Unteransicht,
Fig. 3 die Bauteile eines zweiten, nicht erfindungsgemässen Steuergeräts in einem vereinfachten Längsschnitt,
Fig. 4 die Bauteile des zweiten Steuergeräts in einer perspektivischen Unteransicht,
Fig. 5 die Bauteile eines dritten Steuergeräts in einem vereinfachten Längsschnitt,
Fig. 6 die Bauteile des Steuergeräts des dritten Steuergeräts in einer perspektivischen Oberansicht,
Fig. 7 die Bauteile eines vierten Steuergeräts in einem vereinfachten Längsschnitt und
Fig. 8 die Bauteile eines fünften Steuergeräts in einem Längsschnitt.

Gleiche Elemente bzw. Elemente mit gleicher Funktion sind in den Figuren mit den gleichen Bezugsziffern versehen.

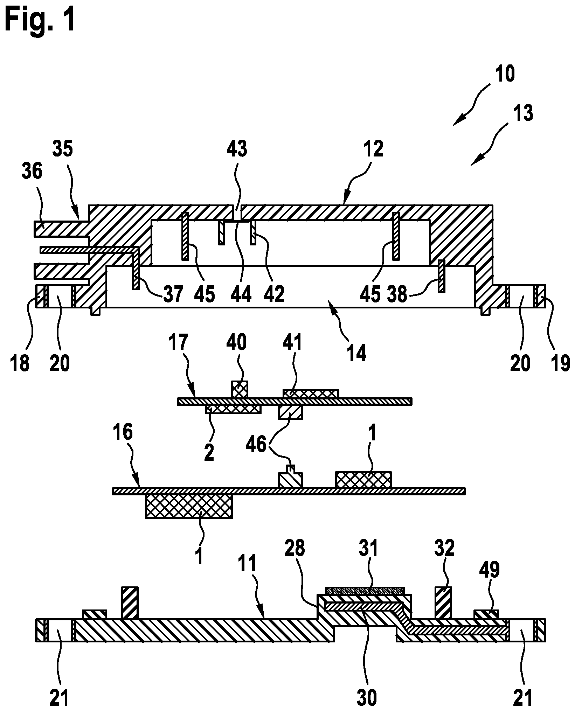

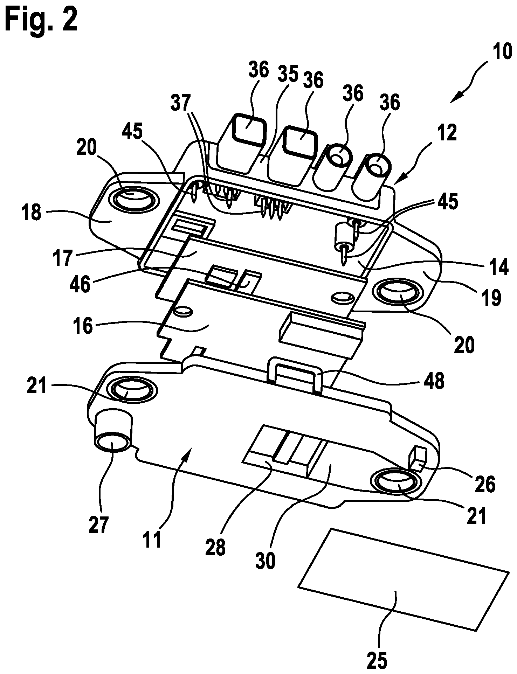

In den Fig. 1 und 2 sind die Bauteile eines ersten Steuergeräts 10, das nicht der beanspruchten Erfindung entspricht, dargestellt.

Das Steuergerät 10 findet insbesondere Verwendung als Bestandteil eines Navigationssystems bzw. eines Systems zur Feststellung des Orts des Steuergeräts 10 in einem nicht dargestellten Kraftfahrzeug. Hierbei verarbeitet das Steuergerät 10 sowohl Signale, welche über ein nicht dargestelltes (Hochfrequenz)Antennenkabel als Eingangsgröße dem Steuergerät 10 zugeführt werden, als auch Signale von innerhalb des Steuergeräts 10 angeordneten Sensoren, beispielsweise Drucksensoren, Gierratensensoren, Magnetfeldsensoren oder ähnlichen.

Das erste Steuergerät 10 weist ein aus zwei Gehäuseelementen 11, 12 bestehendes Gehäuse 13 auf. Das Gehäuseelement 11 bildet einen Gehäuseboden aus, während das Gehäuseelement 12 deckel- bzw. haubenförmig ausgebildet ist und bei mit dem Gehäuseelement 11 verbundenem Zustand einen Innenraum 14 zur Aufnahme zweier separater, beispielhaft als Leiterplatten ausgebildeter Schaltungsträger 16, 17 ausbildet. Das Gehäuseelement 12 weist zwei flanschartig abstehende Befestigungsabschnitte 18, 19 mit darin ausgebildeten Durchgangsöffnungen 20 auf. Die Durchgangsöffnungen 20 sind im montierten Zustand der beiden Gehäuseelemente 11, 12 in Überdeckung mit Durchgangsöffnungen 21 am Gehäuseelement 11 angeordnet. Mittels nicht dargestellter Befestigungselemente, insbesondere mittels Befestigungsschrauben, lässt sich das Gehäuse 13 an einem lediglich symbolisch und in einem Teilbereich dargestellten Trägerelement 25, beispielsweise einem metallischen Karosserieteil, befestigen.

Zur lagerichtigen Positionierung des Gehäuses 13 zum Trägerelement 25 kann das Gehäuseelement 11 auf der dem Gehäuseelement 12 abgewandten Unterseite zwei, einen unterschiedlichen Querschnitt aufweisende, zapfenförmige Positionierelemente 26, 27 aufweisen (Fig. 2), die mit entsprechenden Öffnungen am Trägerelement 25 zusammenwirken (nicht dargestellt).

Das Gehäuseelement 11 besteht aus Kunststoff und ist vorzugsweise als Spritzgussteil ausgebildet. Es weist eine Erhebung 28 auf, in deren Bereich das Gehäuseelement 11 weiter in den Innenraum 14 hineinragt als in den anderen Bereichen des Gehäuseelements 11. Weiterhin erkennt man, dass in dem Material des Gehäuseelements 11 ein aus Metall bestehendes Wärmeleitelement 30 angeordnet ist, welches von dem Material des Gehäuseelements 11 zumindest bereichsweise umspritzt ist, und das bis in den Bereich wenigstens einer Durchgangsöffnung 21 des Gehäuseelements 11 ragt. In der Fig. 2 ist das Wärmeleitelement 30 der Besseren Erkennbarkeit wegen teilweise freigeschnitten dargestellt. Insbesondere anhand der Darstellung der Fig. 1 erkennt man darüber hinaus, dass das Wärmeleitelement 30 im Bereich der Durchgangsöffnung 21 bündig mit der Oberseite bzw. Unterseite des Gehäuseelements 11 abschließt. Dadurch wird bei einer Befestigung des Gehäuses 13 über üblicherweise aus Metall bestehende Befestigungsschrauben als Befestigungselemente ein Wärmefluss bzw. eine Wärmeableitung über das Wärmeleitelement 30 in Richtung des Trägerelements 25 ermöglicht.

Das Wärmeleitelement 30 wirkt über einen Wärmeleitkleber 31 mit der Unterseite des ersten Schaltungsträgers 16 zusammen. Auf dem ersten Schaltungsträger 16 sind elektrische bzw. elektronische Bauteile 1 angeordnet, wobei wenigstens eines der Bauteile 1 ein wärmeerzeugendes Bauteil 1 ist, dessen Wärme über das Wärmeleitelement 30 aus dem Innenraum 14 des Gehäuses 13 während des Betriebs abgeleitet werden kann. Hierzu ist es vorgesehen, dass die Erhebung 28 in demjenigen Bereich des ersten Schaltungsträgers 16 angeordnet ist, in dessen Bereich sich auch das wärmeerzeugende Bauteil 1 befindet. Der erste Schaltungsträger 16 liegt im Einbauzustand auf dem Gehäuseelement 11 an einer vorzugsweise umlaufenden, von dem Gehäuseelement 11 in Richtung zum ersten Schaltungsträger 16 ragenden, vorzugsweise elastischen Erhebung 32, beispielsweise aus Silikon bestehend, auf.

An dem zweiten Gehäuseelement 12, welches ebenfalls aus Kunststoff besteht und als Spritzgussteil ausgebildet ist, ist ein Steckeranschlusskörper 35 vorgesehen. Der Steckeranschlusskörper 35 wird durch Umspritzen von elektrischen Anschlusselementen 36 mit Kunststoffmaterial gebildet, wobei die Anschlusselemente 36 kunden- bzw. anwendungsspezifisch ausgebildet sein können. Insbesondere ist wenigstens einer der Anschlusselemente 36 als Hochfrequenzanschluss, zum Beispiel in Form einer Hochfrequenzbuchse ausgebildet, über den ein Hochfrequenzsignal an wenigstens einen der Schaltungsträger 16, 17 als Eingangsgröße zugeführt. Der Steckeranschlusskörper 35 kann, wie dargestellt, als von dem Gehäuseelement 12 separates Bauteil oder aber als integraler Bestandteil des Gehäuseelements 12 ausgebildet sein. Für den Fall, dass der Steckeranschlusskörper 35 ein von dem Gehäuseelement 12 separates Element ist, kann die Verbindung mit dem Gehäuseelement 12 durch Umspritzen des Steckeranschlusskörpers 35 mit dem Material des Gehäuseelements 12 erfolgen oder aber auf sonstige Art und Weise, beispielsweise über eine (abgedichtete) Klebeverbindung.

Die Anschlusselemente 36 sind zur Kontaktierung des ersten Schaltungsträgers 16 ausgebildet. Hierzu weisen sie in Richtung zum ersten Schaltungsträger 16 ragende Anschlussbereiche 37 auf, die dazu ausgebildet sind, mit entsprechenden Öffnungen in dem ersten Schaltungsträger 16 zusammenzuwirken, um eine Einpressverbindung auszubilden. Auf der dem Anschlusselement 36 gegenüberliegenden Seite ist in dem Gehäuseelement 12 ein weiteres Verbindungselement 38 (Fig. 1) gezeigt, das ebenfalls in eine entsprechende, in dem ersten Schaltungsträger 16 ausgebildete Öffnung unter Ausbildung einer Presspassung bzw. Pressverbindung eingreift, und der weiteren Stabilisierung bzw. Fixierung des ersten Schaltungsträgers 16 im Gehäuseelement 11 im montierten Zustand dient.

Parallel und in Bezug auf das Gehäuseelement 11 auf der dem Gehäuseelement 11 abgewandten Seite des ersten Schaltungsträgers 16 befindet sich der zweite, ebenfalls als Leiterplatte ausgebildete Schaltungsträger 17. Der zweite Schaltungsträger 17 weist neben weiteren elektrischen bzw. elektronischen Bauteilen 2, welche bevorzugt zumindest im Wesentlichen keine Wärme erzeugen, wenigstens ein Sensorelement 40, 41 auf, die im dargestellten Ausführungsbeispiel auf der dem ersten Schaltungsträger 16 abgewandten Seite des zweiten Schaltungsträgers 17 angeordnet sind. Das eine Sensorelement 40 ist beispielhaft als Drucksensor ausgebildet und im Einbauzustand in Umfangsrichtung von einer Gehäusewand 42 des Gehäuseelements 12 umgeben bzw. umschlossen. Zur Übertragung des Außendrucks auf das Sensorelement 40 ist das Gehäuseelement 12 im Überdeckungsbereich mit dem Sensorelement 40 mit einer Öffnung 43 versehen, in deren Bereich eine Druckmembran 44 angeordnet ist, die eine Übertragung des Außendrucks auf das Sensorelement 40 ermöglicht. Der zweite Schaltungsträger 17 ist mit dem Gehäuse 13 (mechanisch) im Wesentlichen lediglich über das Gehäuseelement 12 verbunden. Hierzu weist das Gehäuseelement 12 in Richtung zum zweiten Schaltungsträger 17 ragende Befestigungselemente 45 auf, welche mit entsprechenden Öffnungen im zweiten Schaltungsträger 17 zusammenwirken. Wesentlich dabei ist, dass die Befestigungselemente 45 zumindest mittelbar als vibrationsdämpfende Befestigungselemente 45 ausgebildet sind. Hierzu kann es beispielsweise vorgesehen sein, dass die Befestigungselemente 45 aus einem weichen bzw. elastischen Material bestehen, so dass über das Gehäuseelement 12 bzw. das Gehäuse 13 übertragene Vibrationen gedämpft auf den das wenigstens eine Sensorelement 40, 41 tragenden Schaltungsträger 17 übertragen werden. Alternativ ist es auch denkbar, dass beispielsweise die Befestigungselemente 45 starr ausgebildet sind, aber die entsprechenden Befestigungsöffnungen an den zweiten Schaltungsträger 17, die mit den Befestigungselementen 45 zusammenwirken, vibrationsdämpfende Eigenschaften, beispielsweise in Form einer elastischen Beschichtung oder einem elastischen Element, aufweisen.

Die beiden Schaltungsträger 16, 17 sind mit einer elektrischen Steckverbindung 46 miteinander verbunden, welche eine elektrische Verbindung zwischen den Bauteilen 2 bzw. den Sensorelementen 40, 41 des Schaltungsträgers 17 mit den Bauteilen 1 des Schaltungsträgers 16 ermöglichen. Wesentlich dabei ist, dass die Steckverbindung 46 als mechanisch schwimmende Steckverbindung 46 ausgebildet ist, d.h., dass über die Steckverbindung 46 zumindest im Wesentlichen von dem Schaltungsträger 16 keine Vibrationen auf den Schaltungsträger 17 übertragen werden.

Die beiden Gehäuseelemente 11, 12 des Gehäuses 13 sind im dargestellten Ausführungsbeispiel mittels einer Rast- bzw. Clipverbindung 48 miteinander verbunden. Zur Sicherstellung der Dichtheit zwischen den beiden Gehäuseelementen 11, 12 weist beispielsweise das Gehäuseelement 11 eine umlaufende Dichtung 49 auf, die im Ausführungsbeispiel mit einem in Überdeckung mit der Dichtung 49 am Gehäuseelement 12 ausgebildeten Vorsprung oder ähnlichem zusammenwirkt. Alternativ ist selbstverständlich auch eine Schraubverbindung zwischen den beiden Gehäuseelementen 11, 12 möglich (nicht dargestellt).

Selbstverständlich liegt es auch im Rahmen der Erfindung, die beiden Gehäuseelemente 11, 12 des Gehäuses 13 mittels einer anderen Verbindungstechnik miteinander zu verbinden, beispielsweise mittels einer Klebeverbindung, einer (Laserstrahl-)Schweißverbindung oder ähnlichem. Wesentlich ist lediglich, dass die beiden Gehäuseelemente 11, 12 dicht miteinander verbunden sind.

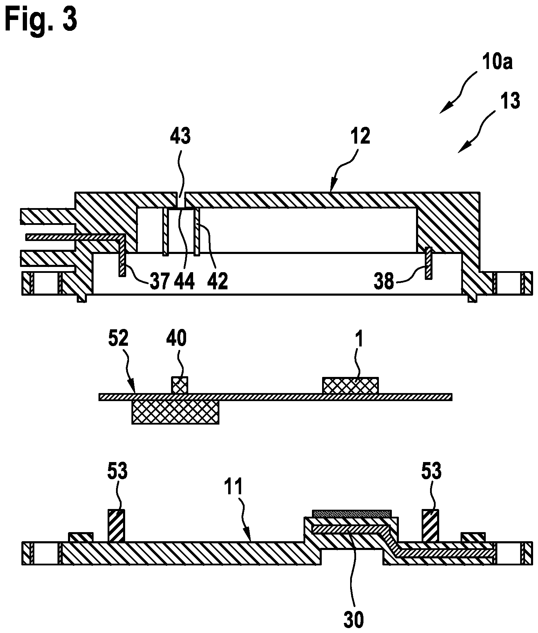

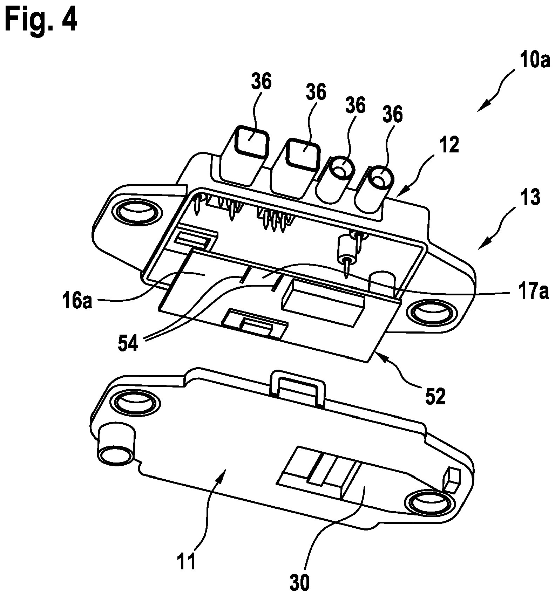

Das in den Fig. 3 und 4 dargestellte zweite Steuergerät 10a, das ebenfalls nicht der beanspruchten Erfindung entspricht, unterscheidet sich von dem Steuergerät 10 dadurch, dass lediglich eine einzige Leiterplatte 52 vorgesehen ist, die sowohl das wenigstens eine wärmeerzeugende Bauteil 1, als auch das wenigstens eine Sensorelement 40 trägt. Die Vibrationsdämpfung zwischen der Leiterplatte 52 und dem Gehäuse 13 wird dadurch bewirkt, dass die Leiterplatte 52 über wenigstens ein an dem Gehäuseelement 11 angeordnetes, aus elastischem Material wie Silikon bestehendes Element 53 gelagert ist. Alternativ oder zusätzlich kann es auch vorgesehen sein, dass die Leiterplatte 52 zur Ausbildung zweier Schaltungsträger 16a, 17a, wie dies anhand der Fig. 4 symbolisch dargestellt ist, im Bereich des wenigstens einen Sensorelements 40 Durchgangsöffnungen, Schlitze 54 oder ähnliches aufweist, die den Bereich, in dem das wenigstens eine Sensorelement 40 auf der Leiterplatte 52 angeordnet ist, zur Ausbildung des zweiten Schaltungsträgers 17a von den Bereichen der Leiterplatte 52 trennt, die den ersten Schaltungsträger 16a mit den Bauteilen 1 ausbildet. Die Verbindung zwischen den beiden Schaltungsträgern 16a, 17a an der Leiterplatte 52 erfolgt somit lediglich noch bereichsweise.

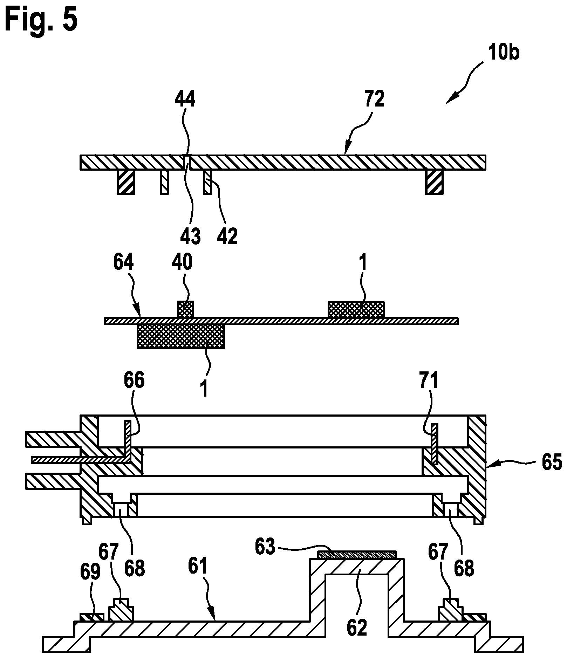

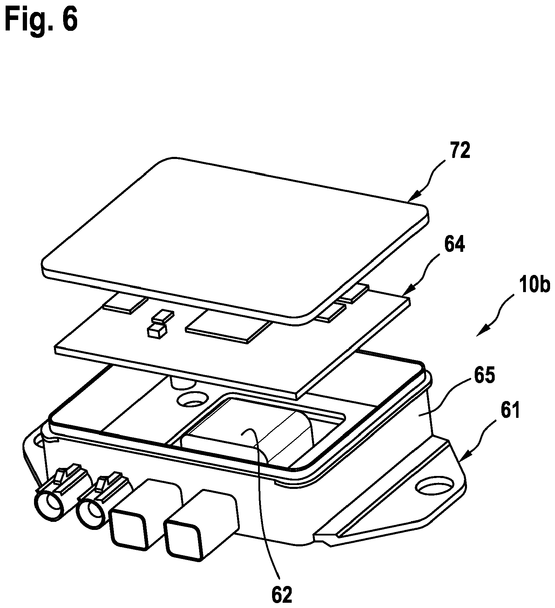

Das in den Fig. 5 und 6 dargestellte dritte Steuergerät 10b weist ein aus Metall, insbesondere aus Blech bestehendes, im Tiefziehverfahren ausgebildetes erstes Gehäuseelement 61 in Form eines Gehäusebodens auf. Das erste Gehäuseelement 61 weist einen erhöhten Bereich 62 auf, der über einen Wärmeleitkleber 63 thermisch mit der Unterseite eines als Leiterplatte ausgebildeten Schaltungsträgers 64 gekoppelt ist. Das Gehäuseelement 61 wirkt somit selbst der Wärmeableitung in Richtung des nicht dargestellten Trägerelements 25. Auf dem Schaltungsträger 64 befinden sich, in Analogie zur Leiterplatte 52 beim zweiten Steuergerät 10a, sowohl die Bauteile 1, von denen wenigstens eines der Bauteile 1 als wärmeerzeugendes Bauteil 1 ausgebildet ist, als auch wenigstens ein Sensorelement 40. Auch beim Steuergerät 10b ist der erhöhte Bereich 62 bzw. der Wärmeleitkleber 63 im Überdeckungsbereich mit dem wenigstens einen wärmeerzeugenden Bauteil 1 angeordnet.

Das erste Gehäuseelement 61 wirkt mit einem aus Kunststoff bestehenden, rahmen- bzw. hülsenartigen zweiten Gehäuseelement 65 zusammen, in dem auch die Anschlusselemente 66 zur elektrischen (und mechanischen) Kontaktierung des Schaltungsträgers 64 angeordnet sind. Die Verbindung zwischen den beiden Gehäuseelementen 61, 65 erfolgt über eine Rast- oder Nietverbindung, wozu an den beiden Gehäuseelementen 61, 65 entsprechende Vorsprünge 67 bzw. damit korrespondierende Öffnungen 68 ausgebildet sind. Die Abdichtung zwischen den beiden Gehäuseelementen 61, 65 erfolgt über ein zwischen den beiden Gehäuseelementen 61, 65 angeordnetes Dichtelement 69.

Eine aus den beiden Gehäuseelementen 61, 65 hergestellte Baueinheit lässt sich mit dem Schaltungsträger 64 verbinden, indem der Schaltungsträger 64 dazu ausgebildet ist, mit den Anschlusselementen 66 sowie zusätzlichen Verbindungselementen 71 eine Einpressverbindung auszubilden, wobei der Schaltungsträger 64 von oben her in Richtung des Gehäuseelements 61 in den Bereich des Gehäuseelements 65 eingeführt wird. Darüber hinaus kann es in Analogie zum zweiten Steuergerät 10a vorgesehen sein, dass der Schaltungsträger 64 im Bereich des wenigstens einen Sensorelements 40 durch entsprechende Aussparungen bzw. Schlitze usw. (nicht dargestellt) Maßnahmen zur Vibrationsdämpfung aufweist, die eine Übertragung von Vibrationen über die Gehäuseelemente 61, 65 auf das Sensorelement 40 vermindern bzw. reduzieren.

Das zweite Gehäuseelement 65 ist auf der dem ersten Gehäuseelement 61 abgewandten Seite mittels eines aus Kunststoff bestehenden Gehäusedeckels, der ein drittes Gehäuseelement 72 ausbildet, verschließbar. Die Verbindung zwischen den beiden Gehäuseelementen 64, 72 erfolgt in an sich bekannter Art und Weise beispielsweise über eine Klebeverbindung oder eine (Laser-)Schweißnaht, wobei mittels an sich üblicher Technologien eine Mediendichtheit zwischen den Gehäuseelementen 65, 72 gewährleistet wird.

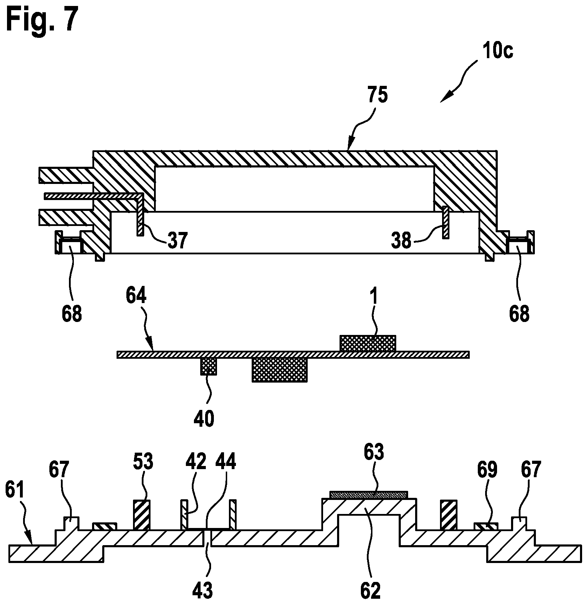

Die Bauteile des in der Fig. 7 dargestellten vierten Steuergeräts 10c unterscheiden sich von den Bauteilen des Steuergeräts 10b entsprechend der Fig. 5 und 6 im Wesentlichen dadurch, dass die beiden Gehäuseelemente 65, 72 durch ein einstückiges, deckel- bzw. haubenförmiges Gehäuseelement 75 ersetzt sind. Das Gehäuseelement 75 besteht ebenfalls aus Kunststoff und ist im Spritzgußverfahren hergestellt. Der Herstellprozess des vierten Steuergeräts 10c erfolgt dadurch, dass der Schaltungsträger 64 mit den Anschlusselementen 66 sowie den Verbindungselementen 71, welche eine Einpressverbindung ausbilden, verbunden wird. Anschließend wird der aus dem Schaltungsträger 64 und dem Gehäuseelement 75 bestehende Verbund mit dem aus Metall bestehenden ersten Gehäuseelement 61 verbunden, welches insbesondere auch die Wärmeabfuhr des wenigstens einen wärmeerzeugenden Wärmeelements 1 ermöglicht. Weiterhin ist bei dem Steuergerät 10c das wenigstens eine Sensorelement 40 auf der dem Gehäuseelement 61 zugewandten Seite des Schaltungsträgers 64 angeordnet, wozu in dem Gehäuseelement 61 eine entsprechende Öffnung 43 sowie Druckmembran 44 ausgebildet sind.

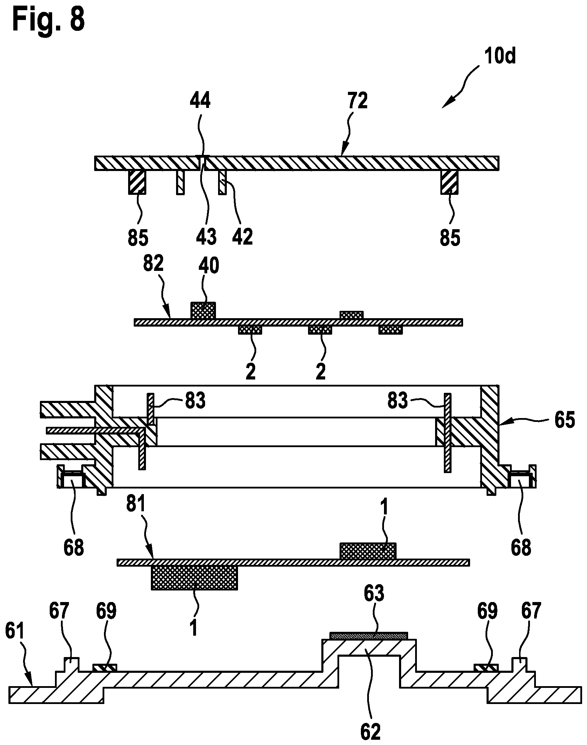

Zuletzt sind in der Fig. 8 die Bauteile eines fünften Steuergeräts 10d dargestellt. Der Aufbau des fünften Steuergeräts 10d entspricht im Wesentlichen dem des dritten Steuergeräts 10b entsprechend der Fig. 5 und 6. Im Gegensatz zum Steuergerät 10b weist das Steuergerät 10d zwei als Leiterplatten ausgebildete Schaltungsträger 81, 82 auf. Während der erste Schaltungsträger 81 das wenigstens eine wärmeerzeugende Bauteil 1 trägt, trägt der zweite Schaltungsträger 82 das wenigstens eine Sensorelement 40. Darüber hinaus ist der zweite Schaltungsträger 82 über an dem zweiten Gehäuseelement 65 angeordnete stiftartige Verbindungselemente 83, welche eine Einpressverbindung ausbilden, mechanisch mit dem zweiten Gehäuseelement 65 und auch elektrisch mit dem ersten Schaltungsträger 81 verbunden. An dem deckelförmigen dritten Gehäuseelement 72 sind auf der dem zweiten Schaltungsträger 82 zugewandten Seite Vibrationsdämpfungselemente 85, beispielsweise bestehend aus Silikon bestehend angeordnet, die eine Vibrationsdämpfung von über das zweite Gehäuseelement 65 auf den zweiten Schaltungsträger 82 übertragenen Vibrationen bewirken.

Das soweit beschriebene Steuergerät 10b bis 10d kann in vielfältiger Art und Weise abgewandelt bzw. modifiziert werden, ohne von der Erfindung, wie sie in den beigefügten Ansprüchen definiert ist, abzuweichen.

## Patentansprüche

1. Steuergerät (10b bis 10d), insbesondere zur Fahrzeugnavigation oder zum automatisierten Fahren, mit einem aus wenigstens einem ersten und einem zweiten Gehäuseelement (61, 72; 75) bestehenden Gehäuse (13), mit wenigstens einem ersten Schaltungsträger (64; 81), auf dem wenigstens ein wärmeerzeugendes Bauteil (1) angeordnet ist, mit einem aus Metall bestehenden Wärmeleitelement (61) zur Ableitung der von dem wenigstens einen wärmeerzeugenden Bauteil (1) erzeugten Wärme, mit wenigstens einem Sensorelement (40), das zumindest auf dem wenigstens einen ersten Schaltungsträger (64, 81) oder auf einem zum ersten Schaltungsträger (64, 81) parallel angeordneten zweiten Schaltungsträger (82) angeordnet ist, wobei auf der dem zweiten Schaltungsträger (82) abgewandten Seite des ersten Schaltungsträgers (81) das zweite Gehäuseelement (61) und auf der dem ersten Schaltungsträger (81) abgewandten Seite des zweiten Schaltungsträgers (82) das erste Gehäuseelement (72) angeordnet ist, und mit wenigstens einem aus Kunststoff bestehenden Steckeranschlusskörper (35) mit Anschlusselementen (36) zur elektrischen Kontaktierung des wenigstens ersten Schaltungsträgers (64; 81), wobei der Steckeranschlusskörper (35) im Bereich eines aus Kunststoff bestehenden, deckelartigen ersten Gehäuseelements (72; 75) oder eines zwischen dem ersten und dem zweiten Gehäuseelement (61; 72; 75) angeordneten rahmenartigen weiteren Gehäuseelementes (65) einstückig mit diesem oder als vom ersten, zweiten oder weiteren Gehäuseelement (61; 72; 75) separates Bauteil ausgebildet ist, und wobei das Wärmeleitelement (61) durch ein aus Metall bestehendes zweites Gehäuseelement (61) in Form eines Gehäusebodens ausgebildet ist, welcher in einem Überdeckungsbereich mit dem wenigstens einen wärmeerzeugenden Bauteil (1) einen erhöhten Bereich (62) aufweist, wobei der erhöhte Bereich (62) thermisch über einen Wärmeleitkleber (31) mit dem wenigstens einen ersten Schaltungsträger (61) für das wenigstens eine wärmeerzeugendes Bauteil (1) gekoppelt ist, und wobei an einer dem Sensorelement (40) aufweisenden ersten Schaltungsträger (64) zugewandten Seite des zweiten Gehäuseelementes (61) bzw. an einer dem Sensorelement (40) aufweisenden zweiten Schaltungsträger (82) zugewandten Seite des ersten Gehäuseelementes (72) Vibrationsdämpfungselemente (53, 85) angeordnet sind, die eine Vibrationsdämpfung von diesem jeweiligen Gehäuseelement (61; 72;) auf den den Sensor (40) aufweisenden ersten bzw. zweiten Schaltungsträger (64; 81; 82) übertragenen Vibrationen bewirken, und wobei zur Übertragung des Außendrucks auf einen Drucksensor als das zumindest eine Sensorelement (40) das dem Drucksensor zugewandte erste bzw. zweite Gehäuseelement (61, 72) im Überdeckungsbereich mit dem Drucksensor (40) eine Öffnung (43) aufweist, in deren Bereich eine Druckmembran (44) angeordnet ist, die eine Übertragung des Außendrucks auf den Drucksensor (40) ermöglicht, wobei der Drucksensor im Einbauzustand in Umfangsrichtung von einer Gehäusewand (42) des ersten bzw, zweiten Gehäuseelements (61; 72) umgeben bzw. umschlossen ist.

2. Steuergerät nach Anspruch 1,
**dadurch gekennzeichnet,**
**dass** das deckelartige zweite Gehäuseelement (72, 75) oder das rahmenartige weitere Gehäuseelement (65) über eine Rast- oder Nietverbindung mit dem Gehäuseboden (61) verbunden ist, wozu an den beiden Gehäuseelementen (61, 65, 75) entsprechende Vorsprünge (67) bzw. damit korrespondierende Öffnungen (68) ausgebildet sind.

3. Steuergerät nach Anspruch 1 oder 2,
**dadurch gekennzeichnet, dass**
eine Abdichtung zwischen dem beiden Gehäuseelementen (61; 65, 72, 75) über ein zwischen den beiden Gehäuseelementen (61; 65, 72, 75) angeordnetes Dichtelement (69) erfolgt.

4. Steuergerät nach Anspruch 1,
**dadurch gekennzeichnet,**
**dass** der das wenigstens eine Sensorelement (40) tragende zweite Schaltungsträger (82) ausschließlich mit dem das wenigstens eine wärmeerzeugende Bauteil (1) tragende erste Schaltungsträger ( 81) elektrisch verbunden ist, vorzugsweise durch eine mechanisch schwimmende Verbindung (46).

5. Steuergerät nach Anspruch 1,
**dadurch gekennzeichnet,**
**dass** der das wenigstens eine Sensorelement (40) tragende zweite Schaltungsträger (82) mit dem das wenigstens eine wärmeerzeugende Bauteil (1) tragenden erste Schaltungsträger (81) über am weiteren Gehäuseelement (65) angeordnete Verbindungselemente (83) mechanisch gekoppelt ist.

6. Steuergerät nach einem der Ansprüche 1 oder 2,
**dadurch gekennzeichnet,**
**dass** ein rahmenförmiges weitere Gehäuseelement (65) von einem aus Kunststoff bestehenden Gehäuseelement (72), das einen Gehäusedeckel ausbildet, verschlossen ist.

7. Steuergerät nach einem der Ansprüche 1 oder 2,
**dadurch gekennzeichnet,**
**dass** die Kontaktierung zwischen den Anschlusselementen (36) und dem wenigstens ersten oder zweiten Schaltungsträger ( 81, 82) über Einpressverbindungen (37; 66; 83) ausgebildet ist.

8. Steuergerät nach einem der Ansprüche 1 bis 4,
**dadurch gekennzeichnet,**
**dass** wenigstens eines der Anschlusselemente (36) als Hochfrequenzanschluss ausgebildet ist.

## Claims

1. Control unit (10b to 10d), in particular for vehicle navigation or for automated driving, having a housing (13) which is composed of at least a first and a second housing element (61, 72; 75), having at least one first circuit carrier (64; 81) on which at least one heat-generating component (1) is arranged, having a heat-conducting element (61) which is composed of metal and which serves for dissipating the heat generated by the at least one heat-generating component (1), having at least one sensor element (40) which is arranged at least on the at least one first circuit carrier (64, 81) or on a second circuit carrier (82) which is arranged parallel to the first circuit carrier (64, 81), wherein the second housing element (61) is arranged on that side of the first circuit carrier (81) which is remote from the second circuit carrier (82) and the first housing element (72) is arranged on that side of the second circuit carrier (82) which is remote from the first circuit carrier (81), and having at least one plug connector body (35) which is composed of plastic and which has connector elements (36) for the electrical contacting of the at least first circuit carrier (64; 81), wherein the plug connector body (35) is, in the region of a lid-like first housing element (72; 75) composed of plastic, or of a frame-like further housing element (65) arranged between the first and the second housing element (61; 72; 75), formed in one piece with said housing element or formed as a component separate from the first, second or further housing element (61; 72; 75), and wherein the heat-conducting element (61) is formed by a second housing element (61) which is composed of metal and is in the form of a housing base which has a raised region (62) in a region of overlap with the at least one heat-generating component (1), wherein the raised region (62) is thermally coupled via a heat-conducting adhesive (31) to the at least one first circuit carrier (61) for the at least one heat-generating component (1), and wherein vibration-damping elements (53, 85) are arranged on a side of the second housing element (61) facing the first circuit carrier (64) having the sensor element (40) or on a side of the first housing element (72) facing the second circuit carrier (82) having the sensor element (40), said vibration-damping elements damping vibrations transmitted from said respective housing element (61; 72) to the first or second circuit carrier (64; 81; 82) having the sensor (40), and wherein, in order to transmit the external pressure to a pressure sensor as the at least one sensor element (40), the first or second housing element (61, 72) facing the pressure sensor, in the region of overlap with the pressure sensor (40), has an opening (43), in the region of which a pressure membrane (44) is arranged which enables the external pressure to be transmitted to the pressure sensor (40), wherein the pressure sensor in the installed state is surrounded or enclosed in the circumferential direction by a housing wall (42) of the first or second housing element (61; 72).

2. Control unit according to Claim 1,
**characterized in that**
the lid-like second housing element (72, 75) or the frame-like further housing element (65) is connected to the housing base (61) via a latching or rivet connection, for which purpose corresponding protrusions (67) and openings (68) corresponding thereto are formed on the two housing elements (61, 65, 75).

3. Control unit according to Claim 1 or 2,
**characterized in that**
sealing between the two housing elements (61; 65, 72, 75) is undertaken via a sealing element (69) arranged between the two housing elements (61; 65, 72, 75).

4. Control unit according to Claim 1,
**characterized in that**
the second circuit carrier (82) which bears the at least one sensor element (40) is electrically connected, preferably by means of a mechanically floating connection (46), exclusively to the first circuit carrier (81) which bears the at least one heat-generating component (1).

5. Control unit according to Claim 1,
**characterized in that**
the second circuit carrier (82) which bears the at least one sensor element (40) is mechanically coupled to the first circuit carrier (81) which bears the at least one heat-generating component (1) via connecting elements (83) arranged on the further housing element (65).

6. Control unit according to either of Claims 1 and 2,
**characterized in that**
a frame-shaped further housing element (65) is closed by a housing element (72) which is composed of plastic and forms a housing lid.

7. Control unit according to either of Claims 1 and 2,
**characterized in that**
the contacting between the connector elements (36) and the at least first or second circuit carrier (81, 82) is formed by means of press-fit connections (37; 66; 83).

8. Control unit according to any of Claims 1 to 4,
**characterized in that**
at least one of the connector elements (36) is formed as a high-frequency connector.

## Revendications

1. Dispositif de commande (10b à 10d), en particulier pour la navigation de véhicule ou la conduite automatisée, avec un boîtier (13) composé d'au moins un premier et un deuxième élément de boîtier (61, 72 ; 75), avec au moins un premier support de circuit (64 ; 81), sur lequel est agencé au moins un composant (1) générateur de chaleur, avec un thermoconducteur (61) en métal destiné à dissiper la chaleur générée par ledit au moins un composant (1) générateur de chaleur, avec au moins un élément capteur (40) qui est agencé au moins sur ledit au moins un premier support de circuit (64, 81) ou sur un deuxième support de circuit (82) agencé parallèlement au premier support de circuit (64, 81), le deuxième élément de boîtier (61) étant agencé sur le côté du premier support de circuit (81) opposé au deuxième support de circuit (82) et le premier élément de boîtier (72) étant agencé sur le côté du deuxième support de circuit (82) opposé au premier support de circuit (81), et avec au moins un corps (35) de raccordement par enfichage en matière synthétique pourvu d'éléments de raccordement (36) destinés à établir un contact électrique dudit au moins premier support de circuit (64 ; 81), le corps (35) de raccordement par enfichage étant, dans la zone d'un premier élément de boîtier (72 ; 75) en forme de couvercle, réalisé en matière synthétique, ou d'un autre élément de boîtier (65) en forme de cadre, agencé entre le premier et le deuxième élément de boîtier (61 ; 72 ; 75), d'une seule pièce avec celui-ci ou en tant que composant séparé du premier, du deuxième ou de l'autre élément de boîtier (61 ; 72 ; 75), et dans lequel l'élément thermoconducteur (61) est sous la forme d'un deuxième élément de boîtier (61) en métal sous la forme d'un fond de boîtier, qui présente une zone surélevée (62) dans une zone de recouvrement avec ledit au moins un composant (1) générateur de chaleur, la zone surélevée (62) étant reliée thermiquement par le biais d'un adhésif thermoconducteur (31) audit au moins un premier support de circuit (61) pour ledit au moins un composant (1) générateur de chaleur, et des éléments (53, 85) d'amortissement de vibrations sont agencés sur un côté du deuxième élément de boîtier (61) tourné vers le premier support de circuit (64) présentant l'élément capteur (40) ou sur un côté du premier élément de boîtier (72) tourné vers le deuxième support de circuit (82) présentant l'élément capteur (40), qui provoquent un amortissement des vibrations transmises par cet élément de boîtier respectif (61 ; 72) au premier ou au deuxième support de circuit (64 ; 81 ; 82) présentant le capteur (40), et dans lequel, pour la transmission de la pression extérieure à un capteur de pression en tant qu'au moins un élément capteur (40), le premier ou le deuxième élément de boîtier (61, 72) tourné vers le capteur de pression présente une ouverture (43) dans la zone de recouvrement avec le capteur de pression (40), dans la zone de laquelle est agencée une membrane de pression (44) qui permet une transmission de la pression extérieure au capteur de pression (40), le capteur de pression étant, à l'état monté, entouré ou enfermé dans la direction périphérique par une paroi de boîtier (42) du premier ou du deuxième élément de boîtier (61 ; 72).

2. Dispositif de commande selon la revendication 1,
**caractérisé**
**en ce que** le deuxième élément de boîtier (72, 75) en forme de couvercle ou l'autre élément de boîtier (65) en forme de cadre est relié au fond du boîtier (61) par une liaison par encliquetage ou par rivetage, ce pourquoi des saillies (67) correspondantes ou des ouvertures (68) correspondantes sont formées sur les deux éléments de boîtier (61, 65, 75).

3. Dispositif de commande selon la revendication 1 ou la revendication 2, **caractérisé en ce que**
une étanchéité entre les deux éléments de boîtier (61 ; 65, 72, 75) est assurée par un élément d'étanchéité (69) agencé entre les deux éléments de boîtier (61 ; 65, 72, 75).

4. Dispositif de commande selon la revendication 1,
**caractérisé**
**en ce que** le deuxième support de circuit (82) portant ledit au moins un élément capteur (40) est relié électriquement exclusivement au premier support de circuit (81) portant ledit au moins un composant (1) générateur de chaleur, de préférence par le biais d'une liaison mécanique flottante (46).

5. Dispositif de commande selon la revendication 1,
**caractérisé**
**en ce que** le deuxième support de circuit (82) portant ledit au moins un élément de capteur (40) est relié mécaniquement au premier support de circuit (81) portant ledit au moins un composant (1) générateur de chaleur par l'intermédiaire d'éléments de liaison (83) agencés sur l'autre élément de boîtier (65).

6. Dispositif de commande selon l'une des revendications 1 ou 2,
**caractérisé**
**en ce qu'**un autre élément de boîtier (65) en forme de cadre est fermé par un élément de boîtier (72) en matière synthétique, qui forme un couvercle de boîtier.

7. Dispositif de commande selon l'une des revendications 1 ou 2,
**caractérisé**
**en ce que** le contact entre les éléments de raccordement (36) et ledit au moins premier ou deuxième support de circuit (81, 82) est formé par des liaisons par enfoncement (37 ; 66 ; 83).

8. Dispositif de commande selon l'une des revendications 1 à 4,
**caractérisé**
**en ce qu'**au moins l'un des éléments de connexion (36) est conçu sous la forme d'un raccord à haute fréquence.
